# EUROPEAN PATENT SPECIFICATION

(11) **EP 3 839 005 B1**
(45) Date of publication and mention of the grant of the patent: **19.07.2023**
(21) Application number: 20211073.0
(22) Date of filing: 12.10.2016
(51) Int. Cl.: C09K 5/06, C08K 3/08, C08K 3/22, C08K 5/00, H01L 23/373

(54) **THERMAL INTERFACE MATERIALS INCLUDING COLORING AGENT**
THERMISCHE ZWISCHENMATERIALEN MIT FÄRBEMITTEL
MATÉRIAUX D'INTERFACE THERMIQUE COMPRENANT UN AGENT COLORANT

(43) Date of publication of application: 23.06.2021
(62) Divisional of application: 16918509.7
(73) Proprietor: Honeywell International Inc., Morris Plains, NJ 07950 (US)
(72) Inventor: ZHANG, Li Qiang, Morris Plains, NJ New Jersey NJ 07950 (US); MAO, Ya Qin, Morris Plains, NJ New Jersey NJ 07950 (US); DUAN, Hui Feng, Morris Plains, NJ New Jersey NJ 07950 (US); KANG, Hai Gang, Morris Plains, NJ New Jersey NJ 07950 (US); LIU, Ya Qun, Morris Plains, NJ New Jersey NJ 07950 (US); SHEN, Ling, Morris Plains, NJ New Jersey NJ 07950 (US); ZHANG, Kai, Morris Plains, NJ New Jersey NJ 07950 (US)
(74) Representative: Stepney, Gregory John

(56) References cited:
- WO-A1-01/21393
- US-A1- 2012 228 542
- US-A1- 2014 171 567

## Description

### FIELD OF THE INVENTION

The present disclosure relates generally to thermal interface materials for use in electronic components, and more particularly to thermal interface materials including a coloring agent.

### DESCRIPTION OF THE RELATED ART

Thermal interface materials (TIMs) are widely used to dissipate heat from electronic components, such as central processing units, video graphics arrays, servers, game consoles, smart phones, LED boards, and the like. Thermal interface materials are typically used to transfer excess heat from the electronic component to a heat spreader, such as a heat sink. Examples of TIM materials from the prior art are described in US2014/171567A1, US2012/228542A1 and WO01/21393A1.

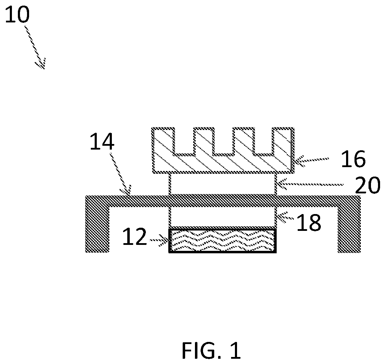

A typical electronics package structure 10 including thermal interface materials is illustrated in FIG. 1. The electronics package structure 10 illustratively includes a heat generating component, such as an electronic chip 12, and one or more heat dissipating components, such as a heat spreader 14, and a heat sink 16. Illustrative heat spreaders 14 and heat sinks comprise a metal, metal alloy, or metal-plated substrate, such as copper, copper alloy, aluminum, aluminum alloy, or nickel-plated copper. TIM materials, such as TIM 18 and TIM 20, provide a thermal connection between the heat generating component and the one or more heat dissipating components. Electronics package structure 10 includes a first TIM 18 connecting the electronic chip 12 and heat spreader 14. TIM 18 is typically referred to as a "TIM 1". Electronics package structure 10 includes a second TIM 20 connecting the heat spreader 14 and heat sink 16. TIM 18 is typically referred to as a "TIM 2". In another embodiment, electronics package structure 10 does not include a heat spreader 14, and a TIM (not shown) connects the electronic chip 12 directly to the heat sink 16. Such a TIM connecting the electronic chip 12 directly to the heat sink 16 is typically referred to as a TIM 1.5.

Thermal interface materials include thermal grease, grease-like materials, elastomer tapes, and phase change materials. Traditional thermal interface materials include components such as gap pads and thermal pads.

Typical TIM materials include a relatively high loading of a thermally conductive filler, such as aluminum particles, providing a grey color to the TIM. In a typical application, the substrate may have a similar grey color as the TIM material, making it difficult for an operator to visually distinguish or an automatic color recognition machine to judge the TIM from the substrate when transferring the TIM onto the substrate or after the TIM has been transferred to the substrate. For thermal interface materials including a white colored filler, such as Al₂O₃, ZnO, or BN, typical pigments may provide adequate color differentiation. However, in thermal interface materials including a darker colored filler, such as aluminum (grey) or carbon black (black), the dark filler colors can cover typical pigments, and little to no color is observed, particularly at relatively high loadings of dark colored fillers.

Improvements in the foregoing are desired.

### SUMMARY OF THE INVENTION

The present disclosure provides thermal interface materials that are useful in transferring heat from heat generating electronic devices, such as computer chips, to heat dissipating structures, such as heat spreaders and heat sinks. The thermal interface material includes a coloring agent.

According to claim 1 of the present disclosure, the thermal interface material includes at least one polymer present in an amount of 5 wt.% to 10 wt.%; at least one thermally conductive filler present in an amount of 85 wt.% to 95 wt.%; .1 wt.% to 5 wt.% of a phase change material comprising at least one wax ; and at least one coloring agent present in an amount of 0.5 wt.% to 20 wt.% based on 100 wt.% of the thermal interface material without the coloring agent, and selected from the group consisting of: an organic pigment, wherein the organic pigment has a formula selected from the group consisting of Formulas (I)- (XVI): 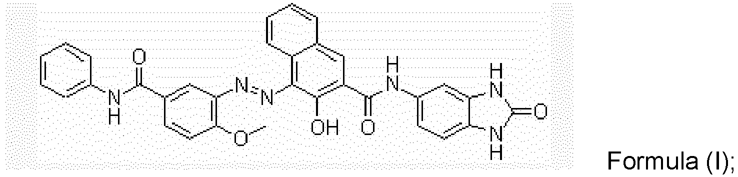 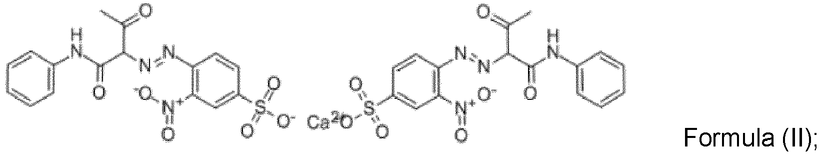 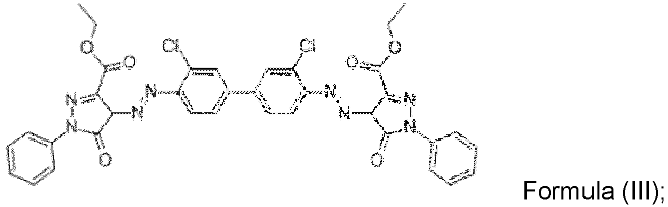 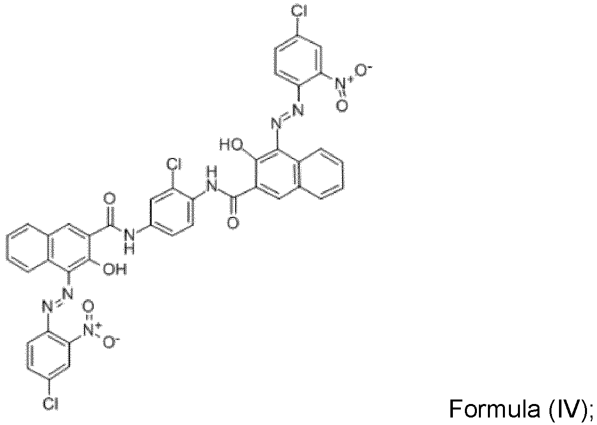 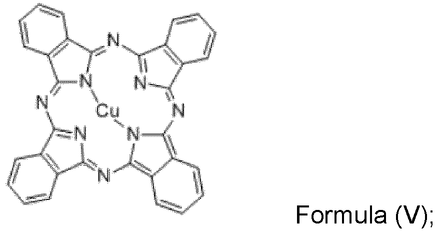 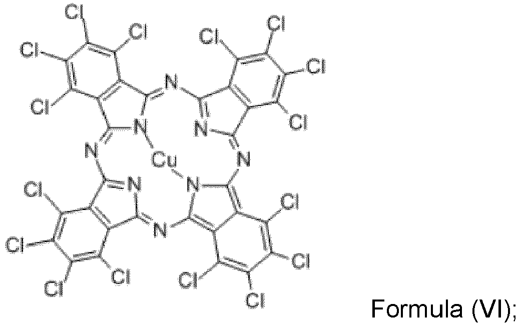 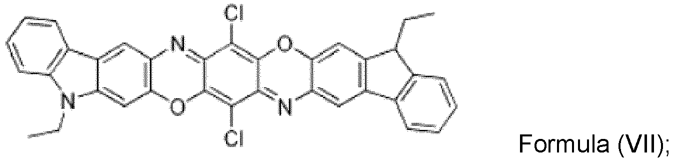 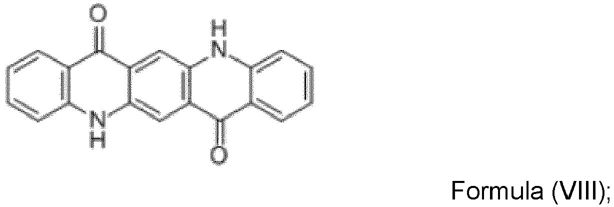 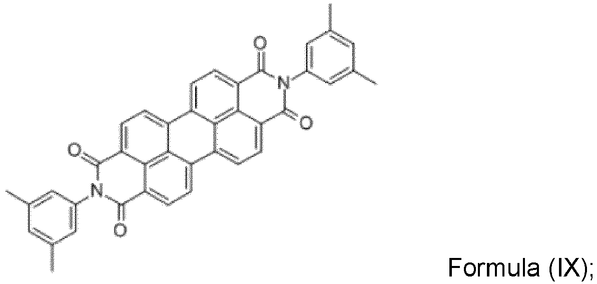 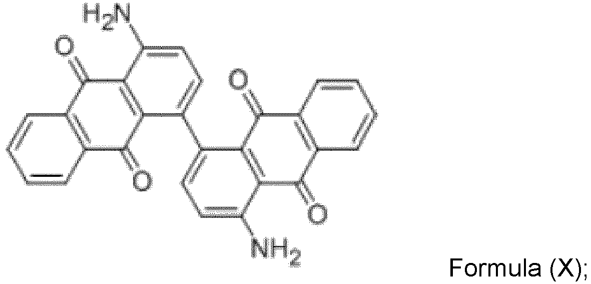 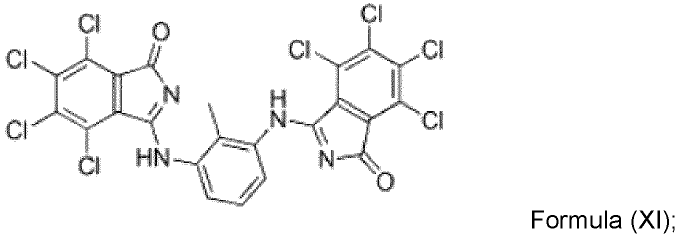 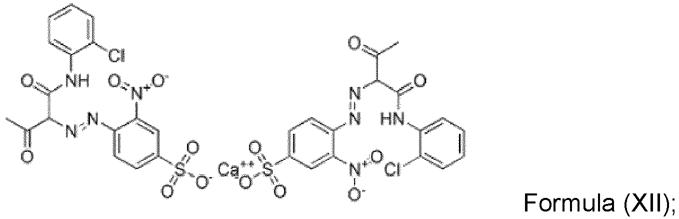 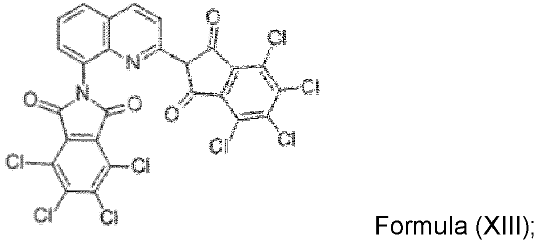 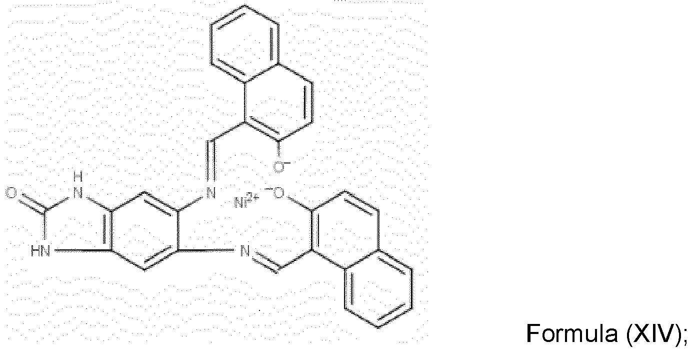 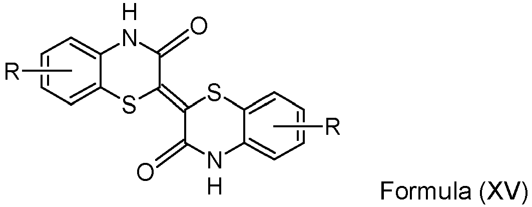 wherein each R is independently selected from H, alkyl, aryl, and halogen; and

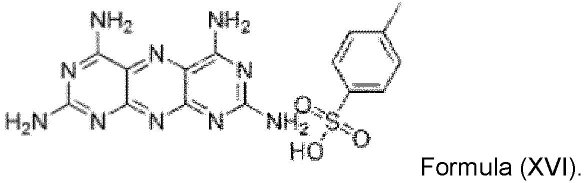

. In one more particular embodiment of any of the above embodiments, the coloring agent is an organic pigment of Formula (I).

In one more particular embodiment of any of the above embodiments, the thermal interface material comprises 1 wt.% to 20 wt.% of the coloring agent based on 100 wt.% of the thermal interface material without the coloring agent.

In one more particular embodiment of any of the above embodiments, the thermally conductive filler comprises aluminum particles. In one more particular embodiment of any of the above embodiments, the aluminum particles comprises at least 80 wt.% of the thermal interface material, based on 100 wt.% of the thermal interface material without the coloring agent.

In one more particular embodiment of any of the above embodiments, the thermal interface material has a thermal impedance of 0.05°C·cm²/W to 0.3°C·cm²/W. In one more particular embodiment of any of the above embodiments, the thermal interface material comprises: 5 wt.% to 10 wt.% of the at least one polymer; 85 wt. % to 95 wt. % of the at least one thermally conductive filler; 0.1 wt. % and 5 wt.% of a phase change material; and 0.5 wt.% to 20 wt.% of the coloring agent, based on 100 wt.% of the thermal interface material without the coloring agent.

According to an embodiment of the present disclosure, a dispensable thermal interface material includes at least one polymer; at least one thermally conductive filler; at least one coloring agent; and at least one solvent as set out in claim 7. The coloring agent is selected from the group consisting of: an organic pigment. The organic pigment has a formula selected from the group consisting of Formulas (I)- (XVI). In one more particular embodiment of any of the above embodiments, the solvent is an isoparaffinic fluid. In one more particular embodiment of any of the above embodiments, the solvent comprises from 1 wt.% to 20 wt.% based on the total weight of a mixture including the thermal interface material and the solvent. In one more particular embodiment of any of the above embodiments, the dispensable thermal interface material as described above has the viscosity in the range of 10 Pa.s to 100,000 Pa.s.

In one more particular embodiment of any of the above embodiments, the coloring agent is an organic pigment of Formula (I).

According to an embodiment of the present disclosure, an electronic component includes: a heat sink; a substrate; a thermal interface material positioned between the heat sink and the substrate, the thermal interface material including: at least one polymer; at least one thermally conductive filler; and one coloring agent selected from the group consisting of an organic pigment, as set out in claim 11. The organic pigment has a formula selected from the group consisting of Formulas (I)-(XVI).

### BRIEF DESCRIPTION OF THE DRAWINGS

The above-mentioned and other features and advantages of this disclosure, and the manner of attaining them, will become more apparent and the invention itself will be better understood by reference to the following description of embodiments of the invention taken in conjunction with the accompanying drawings, wherein:
FIG. 1 schematically illustrates a typical electronics package structure;
Figure 2A is related to the Examples and shows the thermal interface material of Comparative Example 1 screen printed at 0.5 mm on paper.
Figure 2B is related to the Examples and shows the thermal interface material of Comparative Example 1 screen printed at 0.5 mm on a substrate.
Figure 3A is related to the Examples and shows the thermal interface material of Example 1 screen printed at 0.5 mm on paper.
Figure 3B is related to the Examples and shows the thermal interface material of Example 1 screen printed at 0.5 mm on a substrate.
Figure 3C is related to the Examples and shows a comparison of the thermal interface material of Comparative Example 1 with Example 1 manually applied to a substrate.
Figure 4A is related to the Examples and shows the thermal interface material of Example 2 screen printed at 0.5 mm on paper.
Figure 4B is related to the Examples and shows the thermal interface material of Example 2 screen printed at 0.5 mm on a substrate.
Figure 4C is related to the Examples and shows a comparison of the thermal interface material of Comparative Example 1 with Example 2 manually applied to a substrate.
Figure 5A is related to the Examples and shows the thermal interface material of Example 3 screen printed at 0.5 mm on paper.
Figure 5B is related to the Examples and shows the thermal interface material of Example 3 screen printed at 0.5 mm on a substrate.
Figure 5C is related to the Examples and shows a comparison of the thermal interface material of Comparative Example 1 with Example 3 manually applied to a substrate.
Figure 6A is related to the Examples and shows the thermal interface material of Example 4 screen printed at 0.5 mm on paper.
Figure 6B is related to the Examples and shows the thermal interface material of Example 4 screen printed at 0.5 mm on a substrate.
Figure 6C is related to the Examples and shows a comparison of the thermal interface material of Comparative Example 1 with Example 4 manually applied to a substrate.
Figure 7A is related to the Examples and shows the thermal interface material of Example 5 screen printed at 0.5 mm on paper.
Figure 7B is related to the Examples and shows the thermal interface material of Example 5 screen printed at 0.5 mm on a substrate.
Figure 7C is related to the Examples and shows a comparison of the thermal interface material of Comparative Example 1 with Example 5 manually applied to a substrate.
Figure 8A is related to the Examples and shows the thermal interface material of Example 6 screen printed at 0.5 mm on paper.
Figure 8B is related to the Examples and shows the thermal interface material of Example 6 screen printed at 0.5 mm on a substrate.
Figure 8C is related to the Examples and shows a comparison of the thermal interface material of Comparative Example 1 with Example 6 manually applied to a substrate.
Figure 9A is related to the Examples and shows the thermal interface material of Example 7 screen printed at 0.5 mm on paper.
Figure 9B is related to the Examples and shows the thermal interface material of Example 7 screen printed at 0.5 mm on a substrate.
Figure 9C is related to the Examples and shows a comparison of the thermal interface material of Comparative Example 1 with Example 7 manually applied to a substrate.
Figure 10A is related to the Examples and shows the thermal interface material of Example 8 screen printed at 0.5 mm on paper.
Figure 10B is related to the Examples and shows the thermal interface material of Example 8 screen printed at 0.5 mm on a substrate.
Figure 10C is related to the Examples and shows a comparison of the thermal interface material of Comparative Example 1 with Example 8 manually applied to a substrate.
Figure 11A is related to the Examples and shows the thermal interface material of Example 9 screen printed at 0.5 mm on paper.
Figure 11B is related to the Examples and shows the thermal interface material of Example 9 screen printed at 0.5 mm on a substrate.
Figure 11C is related to the Examples and shows a comparison of the thermal interface material of Comparative Example 1 with Example 9 manually applied to a substrate.
Figure 12A is related to the Examples and shows the thermal interface material of Example 10 screen printed at 0.5 mm on paper.
Figure 12B is related to the Examples and shows the thermal interface material of Example 10 screen printed at 0.5 mm on a substrate.
Figure 12C is related to the Examples and shows a comparison of the thermal interface material of Comparative Example 1 with Example 10 manually applied to a substrate.
Figure 13 is related to the Examples and shows the thermal interface material of Comparative Example 2 screen printed on a substrate.
Figure 14 is related to the Examples and shows the thermal interface material of Example 11 screen printed on a substrate.
Figure 15 is related to the Examples and shows the thermal impedance of Comparative Example 1, Example 2, Example 3, and Example 5.
Figure 16 is related to the Examples and shows the thermal impedance of Comparative Example 1 and Example 6.

Corresponding reference characters indicate corresponding parts throughout the several views. The exemplifications set out herein illustrate exemplary embodiments of the invention and such exemplifications are not to be construed as limiting the scope of the invention in any manner.

### DETAILED DESCRIPTION

### A. Thermal Interface Material

The present invention relates to thermal interface materials (TIMs) useful in transferring heat away from electronic components. In one embodiment not of the invention, the TIM comprises a polymer matrix, at least one thermally conductive filler, and at least one coloring agent selected from the group consisting of: α-Fe₂O₃; α-Fe₂O₃· H₂O; Fe₃O₄; and an organic pigment selected from the group consisting of Formulas (I) - (XVI). In another embodiment not of the invention, the TIM comprises a polymer matrix, at least one thermally conductive filler, and at least one coloring agent selected from the group consisting of: α-Fe₂O₃; α-Fe₂O₃· H₂O; Fe₃O₄; and an organic pigment of Formula (I).

In some embodiments, the TIM optionally includes one or more of the following components: coupling agent, antioxidant, phase change material, ion scavenger and other additives.

As illustrated in the Examples presented below, the inclusion of the particular pigments in the thermal interface material provided a distinguishable color to the thermal interface material without significantly affecting thermal properties.

### 1. Polymer

The TIM includes a polymer, such as an elastomer. In some embodiments, the polymer comprises a silicone rubber, a siloxane rubber, a siloxane copolymer, or other suitable silicone-containing rubber. In some embodiments, the polymer comprises one or more hydrocarbon rubber compounds, including saturated or unsaturated hydrocarbon rubber compounds.

Exemplary saturated rubbers include ethylene-propylene rubbers (EPR, EPDM), polyethylene/butylene, polyethylene-butylene-styrene, polyethylene-propylene-styrene, hydrogenated polyalkyldiene "mono-ols" (such as hydrogenated polybutadiene mono-ol, hydrogenated polypropadiene mono-ol, hydrogenated polypentadiene mono-ol), hydrogenated polyalkyldiene "diols" (such as hydrogenated polybutadiene diol, hydrogenated polypropadiene diol, hydrogenated polypentadiene diol) and hydrogenated polyisoprene, polyolefin elastomer, and blends thereof. In some embodiments, the polymer is a hydrogenated polybutadiene mono-ol.

Exemplary unsaturated rubbers include polybutadiene, polyisoprene, polystyrene-butadiene and blends thereof, or blends of saturated and unsaturated rubber compounds.

The TIM comprises the one or more polymers in an amount as little as 5 wt. %, 6 wt. %, 7 wt. %, 8 wt. %, as great as 10 wt.%, , or within any range defined between any two of the foregoing values, based on the total weight of the TIM.

### 2. Thermally conductive filler

The TIM includes one or more thermally conductive fillers. Exemplary thermally conductive fillers include metals, alloys, nonmetals, metal oxides, metal nitrides, and ceramics, and combinations thereof. Exemplary metals include, but are not limited to, aluminum, copper, silver, zinc, nickel, tin, indium, lead, silver coated metals such as silver coated copper or silver coated aluminum, metal coated carbon fibers, and nickel coated fibers. Exemplary nonmetals include, but are not limited to, carbon, graphite, carbon nanotubes, carbon fibers, graphene, powdered diamond, glass, silica, silicon nitride, and boron coated particles. Exemplary metal oxides, metal nitrides and ceramics include but are not limited to alumina, aluminum nitride, boron nitride, zinc oxide, and tin oxide.

In some exemplary embodiments, the thermally conductive filler is provided as a plurality of particles. Average particle diameter (D50) is commonly used to measure particle size. Illustrative particles have average particle diameters as little as 10 nm, 20 nm, 50 nm, 0.1 microns, 0.2 microns, 0.5 microns, 1 micron, 2 microns, 3 microns, as great as 5 microns, 8 microns, 10 microns, 12 microns, 15 microns 20 microns, 25 microns, 50 microns, 100 microns, or within any range defined between any two of the foregoing values, such as 10 nm to 100 micron, 0.1 microns to 20 microns, or 0.5 microns to 10 microns, for example.

In one embodiment, the thermally conductive fillers have different particle sizes to increase the packing effect between filler particles. In some embodiments, the first and second thermally conductive fillers are two different types of thermally conductive fillers having different particle sizes. In some embodiments, the first and second thermally conductive fillers are the same thermally conductive filler, but have different particle sizes.

In one exemplary embodiment, the TIM comprise the one or more thermally conductive fillers in a total amount as little as 85 wt.%, 90 wt.%, 95 wt.%, or within any range defined between any two of the foregoing values, such as 85 wt.% to 95 wt.%, for example, based on the total weight of the TIM.

### 3. Coloring agent

The TIM includes a coloring agent. Coloring agents described herein include organic and inorganic pigments and organic dyes. Organic pigments include: benzimidazolone, such as the blue shade benzimidazolone pigment Novoperm Carmine HF3C from Clariant International Ltd, Muttenz Switzerland. Inorganic pigments include carbon black and iron based compounds. Iron based compounds include iron oxide compounds such as α-Fe₂O₃, α-Fe₂O₃·H₂O, Fe₃O₄ and combinations thereof. Organic dyes include: Benzo[kl]thioxanthene-3,4-dicarboximide,N-octadecyl- (8Cl); Benzothioxanthene-3,4-dicarboxylic acid-N-stearylimide.

In some embodiments, not of the invention, the coloring agent is an inorganic pigment selected from the group consisting of α-Fe₂O₃; α-Fe₂O₃· H₂O; and Fe₃O₄.

In the invention, the coloring agent is an organic pigment, particularlyt, the coloring agent is an organic selected from the group consisting of Formulas (I)-(XVI).

In a more particular embodiment, the coloring agent is an organic pigment of Formula (I), also known as pigment red 176, and having CAS No. 12225-06-8.

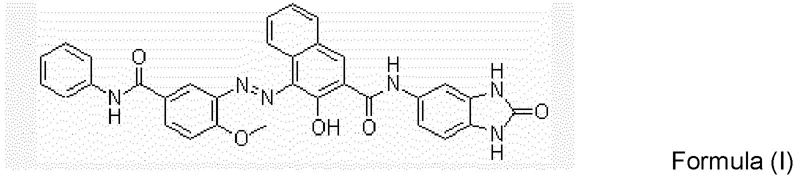

In a more particular embodiment, the coloring agent is an organic pigment of Formula (II), also known as calcium bis[4-[[1-[[(2-methylphenyl)amino]carbonyl]-2-oxopropyl]azo]-3-nitrobenzenesulphonate, and having CAS No. 12286-66-7.

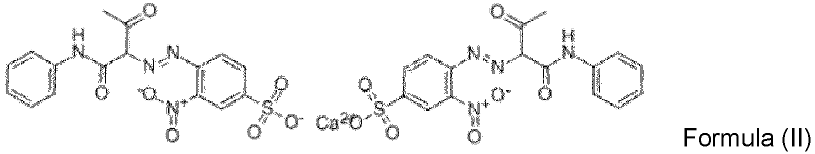

In a more particular embodiment, the coloring agent is an organic pigment of Formula (III) also known as diethyl 4,4'-[(3,3'-dichloro[1,1'-biphenyl]-4,4'-diyl)bis(azo)]bis[4,5-dihydro-5-oxo-1-phenyl-1h-pyrazole-3-carboxylate], and having CAS No. 6358-87-8.

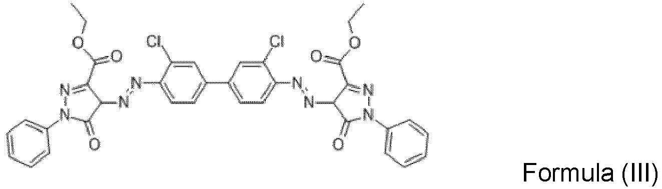

In a more particular embodiment, the coloring agent is an organic pigment of Formula (IV) also known as 2,2'-[(3,3'-Dichloro[1,1'-biphenyl]-4,4'-diyl)bis(azo)]bis[N-(2,4-dimethylphenyl)-3-oxo-butanamide, and having CAS No. 5102-83-0.

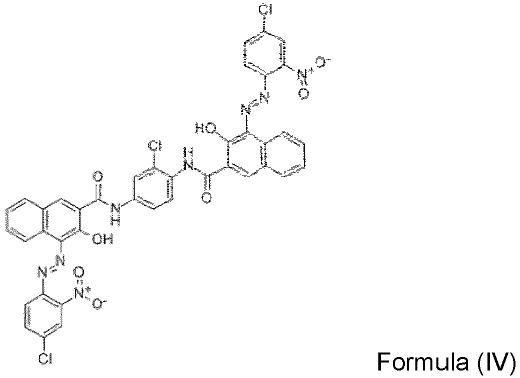

In a more particular embodiment, the coloring agent is an organic pigment of Formula (V) also known as (29H,31H-phthalocyaninato(2-)-N29,N30,N31,N32)copper, and having CAS No. 147-14-8.

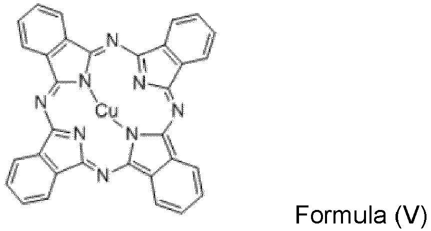

In a more particular embodiment, the coloring agent is an organic pigment of Formula (VI) also known as brilliantgreenphthalocyanine, and having CAS No. 1328-53-6.

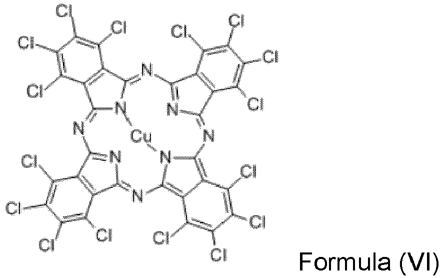

In a more particular embodiment, the coloring agent is an organic pigment of Formula (VII) also known as 9,19-dichloro-5,15-diethyl-5,15-dihydro-diindolo[2,3-c:2',3'-n]triphenodioxazine, and having CAS No. 6358-30-1.

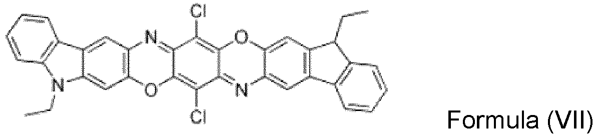

In a more particular embodiment, the coloring agent is an organic pigment of Formula (VIII) also known as 5,12-DIHYDROQUIN[2,3-B]ACRIDINE-7,14-DIONE;5,12-dihydroquino[2,3-b]acridine-7,14-dione, and having CAS No. 1047-16-1.

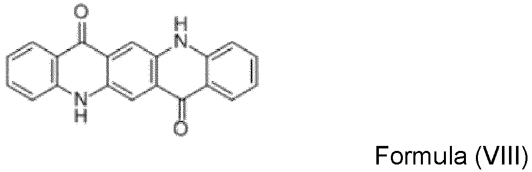

In a more particular embodiment, the coloring agent is an organic pigment of Formula (IX) also known as 2,9-bis(3,5-dimethylphenyl)anthra[2,1,9-def:6,5,10-d'e'f']diisoquinoline-1,3,8,10(2h,9h)-tetrone, and having CAS No. 4948-15-6.

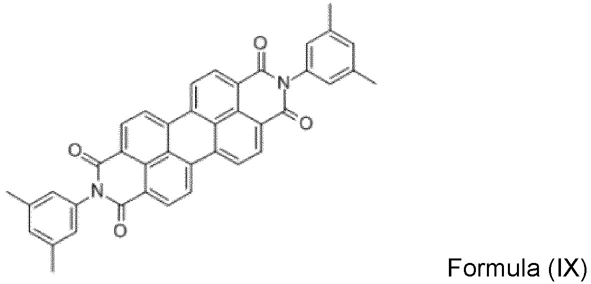

In a more particular embodiment, the coloring agent is an organic pigment of Formula (X) also known as 4,4'-diamino-[1,1'-bianthracene]-9,9',10,10'-tetraone or pigment red 177, and having20CAS No. 4051-63-2.

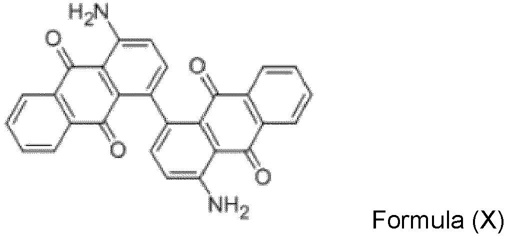

In a more particular embodiment, the coloring agent is an organic pigment of Formula (XI) also known as 3,3'-[(2-methyl-1,3-phenylene)diimino]bis[4,5,6,7-tetrachloro-1H-isoindol-1-one], and having CAS No. 5045-40-9.

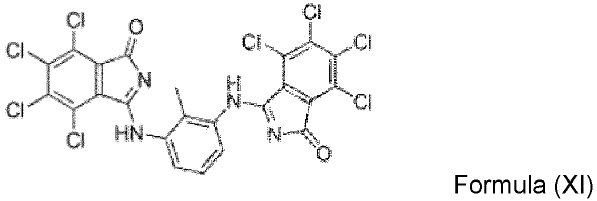

In a more particular embodiment, the coloring agent is an organic pigment of Formula (XII) also known as calcium bis[4-[[1-[[(2-chlorophenyl)amino]carbonyl]-2-oxopropyl]azo]-3-nitrobenzenesulphonate], and having CAS No. 71832-85-4.

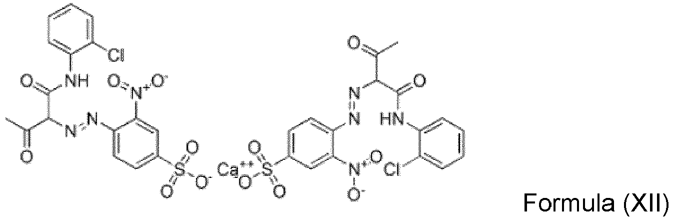

In a more particular embodiment, the coloring agent is an organic pigment of Formula (XIII) also known as 3,4,5,6-Tetrachloro-N-[2-(4,5,6,7-tetrachloro-2,3-dihydro-1,3-dioxo-1H-inden-2-yl)-8-quinolyl]phthalimide, and having CAS No. 30125-47-4.

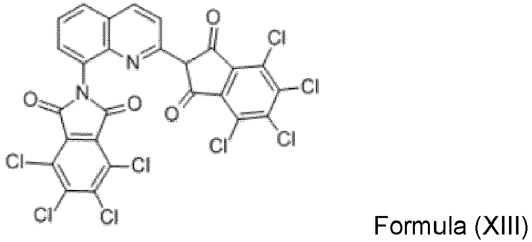

In a more particular embodiment, the coloring agent is an organic pigment of Formula (XIV) also known as [1,3-dihydro-5,6-bis[[(2-hydroxy-1-naphthyl)methylene]amino]-2H-benzimidazol-2-onato(2-)-N5,N6,O5,O6]nickel, and having CAS No. 42844-93-9.

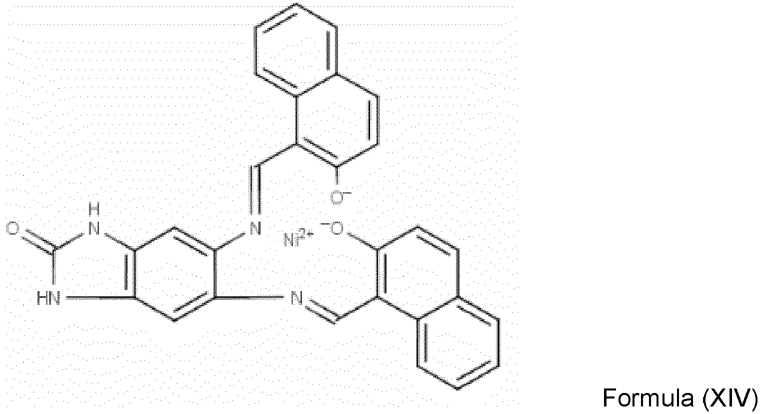

In a more particular embodiment, the coloring agent is an organic pigment of Formula (XV) also known as Pigment Red 279, and having CAS No. 832743-59-6, wherein each R is independently selected from the group consisting of hydrogen, alkyl, aryl, and halogen. In an even more particular embodiment, each R is independently selected from the group consisting of hydrogen, C₁-C₆ alkyl, phenyl, and halogen. In another more particular embodiment, each R is chlorine, and even more particularly, each R is 7-chloro..

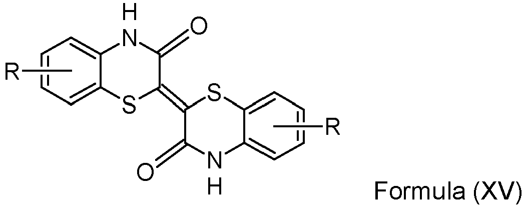

In a more particular embodiment, the coloring agent is an organic pigment of Formula (XVI) also known as Pyrimido[5,4-g]pteridine-2,4,6,8-tetramine, 4-methylbenzenesulfonate, base-hydrolysed, and having20CAS No. 346709-25-9.

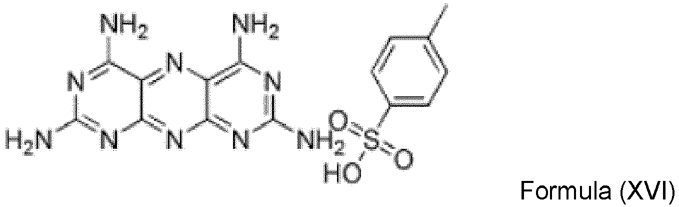

In one more particular embodiment not of the invention, the coloring agent is α-Fe₂O₃, such as such as Iron Red available from BAI YAN. In another more particular embodiment not of the invention, the coloring agent is α-Fe₂O₃·H₂O, such as such as Iron Yellow available from BAI YAN. In still another more particular embodiment not of the invention, the coloring agent is Fe₃O₄, such as such as Iron Blue available from BAI YAN. In yet still another more particular embodiment, the coloring agent is the pigment of Formula (I), having the chemical formula C₃₂H₂₄N₆O₅, such as Novoperm Carmine HF3C, available from Clariant International Ltd, Muttenz Switzerland.

In some exemplary embodiments, the TIM comprises the coloring agent in an amount as little as 0.5 wt.%, 1 wt.%, 1.5 wt.%, as great as 2 wt.%, 5 wt.%, 10 wt.%, 15 wt.%, 20 wt.%, or within any range defined between any two of the foregoing values, such as 0.5 wt.% to 2 wt.%, or 5 wt.% to 20 wt.%, for example, based on 100 wt.% of the thermal interface material without the coloring agent.

### 4. Coupling agent

In some exemplary embodiments, the TIM comprises one or more coupling agents. Exemplary coupling agents include organometallic compounds, such as titanate coupling agents or zircontate coupling agents, and organic compounds, such as silane coupling agents. Exemplary coupling agents include titanium IV 2,2 (bis 2-propenolatomethyl)butanolato, tris(dioctyl)pyrophosphato-O; zirconium IV 2,2 (bis 2-propenolatomethyl)butanolato, tris(diisooctyl)pyrophosphato-O; titanium IV 2-propanolato, tris(dioctyl)-pyrophosphato-O) adduct with 1 mole of diisooctyl phosphite; titanium IV bis(dioctyl)pyrophosphato-O, oxoethylenediolato, (Adduct), bis(dioctyl) (hydrogen)phosphite-O; titanium IV bis(dioctyl)pyrophosphato-O, ethylenediolato (adduct), bis(dioctyl)hydrogen phosphite; and zirconium IV 2,2-bis(2-propenolatomethyl) butanolato, cyclo di[2,2-(bis 2-propenolatomethyl) butanolato], pyrophosphato-O,O.

In some exemplary embodiments, the TIM comprises the one or more coupling agents in an amount as little as 0.1 wt.%, 0.5 wt.%, 0.67 wt.%, 0.75 wt.%, as great as 1 wt.%, 1.5 wt.%, 2 wt.%, 5 wt.%, 10 wt.%, or within any range defined between any two of the foregoing values, such as 0.1 wt.% to 10 wt.%, 0.1 wt.% to 2 wt.%, or 0.5 wt.% to 1 wt.%, for example, based on the total weight of the TIM.

### 5. Antioxidant

In some exemplary embodiments, the TIM comprises one or more antioxidants. Exemplary antioxidants include phenol type, amine type antioxidants, or any other suitable type of antioxidant, or a combination thereof. The phenol or amine type antioxidant may also be a sterically hindered phenol or amine type antioxidant. Exemplary phenol type antioxidants include octadecyl 3-(3,5-di-(tert)-butyl-4-hydroxyphenyl) propionate. Exemplary amine type antioxidants include 2,6-di-tert-butyl-4-(4,6-bis(octylthio)-1,3,5-triazin-2-ylamino) phenol. Exemplary sterically hindered antioxidants include sterically hindered sulfur containing phenolic antioxidants. Exemplary antioxidants include the Irganox ^{®} antioxidants available from BASF.

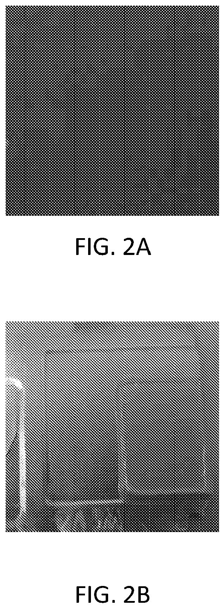

Although ion scavengers and antioxidants both reduce oxidative degradation of the TIM, ion scavengers are believed to function by capturing and binding metal ions in a complex such that the metal ions no longer have a net charge and are effectively disabled from participating in the metal-catalyzed reactions of FIG. 2B. In contrast, antioxidants are generally believed to function by transferring electrons to an oxidizing agent, such as the radicals of FIG. 2A.

In some exemplary embodiments, the TIM comprises the one or more antioxidants in an amount as little as 0.05 wt.%, 0.1 wt.%, 0.5 wt.%, 1 wt.% as great as 1.5 wt.%, 2 wt.%, 5 wt.%, 10 wt.%, or within any range defined between any two of the foregoing values, such as 0.1 wt.% to 10 wt.%, 0.1 wt.% to 2 wt.%, or 0.5 wt.% to 1 wt.%, for example, based on the total weight of the TIM.

### 6. Phase change material

The TIM comprises one or more phase change materials comprising at least one wax. A phase change material is a material having a melting point or melting point range at or below the operating temperature of a portion of an electronic device in which the TIM is to be used. An exemplary phase change material is a wax. Other exemplary phase change materials include low melting alloys, such as Wood's metal, Field's metal, or a metal or alloy having a melting point between about 20°C and 90°C.

In some embodiments, the phase change material has a phase change temperature as low as 20°C, 30°C, 40°C, 45°C 50°C,as high as 60°C, 70°C, 80°C, 90°C, 100°C, 110°C, or within any range defined between any two of the foregoing values. In some more particular embodiments, the phase change material has a phase change temperature as low as 30°C, 40°C, 45°C as high as 50°C, 60°C, 70°C, or within any range defined between any two of the foregoing values.

Exemplary waxes include polyethylene (PE) wax, paraffin wax, AC-1702, a polyethylene wax, AC-430 , a copolymer of ethylene-vinyl acetate wax, and AC-6702, an oxidized polyethylene wax, each available from Honeywell International Inc., a polyethylene wax blended with polytetrafluoroethylene such as PEW-0602F wax available from Nanjing Tianshi New Material Technologies, TAC wax, available from The International Group, Inc., and RT44HC, available from Hangzhou Ruhr Tech.

The TIM comprises the one or more phase change materials in an amount as little as 0.5 wt.%, 1 wt.%, 2 wt.%, 3 wt.%, or as great as 5 wt.%, or within any range defined between any two of the foregoing values, such as 1 wt.% to 5 wt.%, for example, based on the total weight of the TIM.

### 7. Ion scavenger

In some exemplary embodiments, the TIM comprises one or more ion scavengers. Exemplary ion scavengers include nitrogen containing complexing agents, phosphorous containing complexing agents, and hydroxyl carboxylic acid based complexing agents. In some exemplary embodiments, the ion scavenger is selected from acid amide compounds, such as hydrazide or dihydrazide. In some exemplary embodiments, the ion scavenger is selected from triazole compounds, tetrazole compounds, triazene compounds, oxamide comounds, or malonamide compounds. In some exemplary embodiments, the ion scavenger is selected from decamethylenedicarboxylic acid disalicyloylhydrazide; 3-(N-salicyloyl)amino-1,2,4-triazole; and 2', 3-bis [[3-[3, 5-di-tert-butyl-4-hydroxyphenyl] propionic]]propionyl hydrazide.

In another more particular embodiment, the ion scavenger is a compound according to any of the following compounds or combinations thereof: N-salicylidene-N'salicyloyl hydrazide, oxalyl bis(benzylidenehydrazide), N,N'-bis(salicyloyl)hydrazine, 3-(N-salicyloyl)amino-1,2,4-triazole, 2,2'-oxamido bis[ethyl 3-(3,5-di-tert-butyl-4-hydroxyphenyl)propionate], N,N'-bis(salicylidene) ethylenediamine, Oxanilide, Methylmalonic acid dianilide, N-formyl-N'-salicyloyl hydrazine, Decamethylenedicarboxylic acid disalicyloylhydrazide, and Bis(2,6-di-ter-butyl-4-methylphenyl)pentaerythritol-diphosphite.

The TIM comprises the one or more ion scavengers in an amount as little as 0.1 wt.%, 0.2 wt.%, 0.5 wt.%, 1 wt.% as great as 1.5 wt.%, 2 wt.%, 5 wt.%, 10 wt.%, or within any range defined between any two of the foregoing values, such as 0.1 wt.% to 10 wt.%, 0.1 wt.% to 2 wt.%, or 0.5 wt.% to 1 wt.%, for example, based on the total weight of the TIM.

### 8. Other additives

In some exemplary embodiments, the TIM comprises one or more additional additives. Exemplary additives include crosslinkers, such as alkylated melamine formaldehyde resin, and pigments.

In some exemplary embodiments, the TIM comprises the one or more additives in an amount as little as 0.1 wt.%, 0.5 wt.%, 1 wt.% as great as 1.5 wt.%, 2 wt.%, 5 wt.%, 10 wt.%, or within any range defined between any two of the foregoing values, such as 0.1 wt. % to 10 wt. %, 0.1 wt.% to 2 wt. %, or 0.5 wt.% to 1 wt. %, for example, based on the total weight of the TIM.

### 9. Exemplary properties of the Thermal Interface Material

In some exemplary embodiments, a thermal interface material including a coloring agent as described above has a color that visually distinguishes TIM 18 (FIG. 1) from substrate 12 (e.g., chip 12).

In some exemplary embodiments, a thermal interface material including a coloring agent as described above has a thermal impedance approximately the same thermal properties, such as thermal conductivity and thermal impedance, as the thermal properties of a similar thermal interface material that does not include the coloring agent.

In some exemplary embodiments, a thermal interface material including a coloring agent as described above has a thermal conductivity at least 1 W/m.K. An exemplary thermal conductivity test method standard is ASTM D5470.

In some exemplary embodiments, a thermal interface material including a coloring agent as described above has a thermal impedance as little as 0.05°C·m²/W, 0.1°C·cm²/W, 0.15°C·cm²/W, 0.2°C·cm²/W as high as 0.25°C·cm²/W, 0.25°C·cm²/W, 0.3°C·cm²/W, 0.35°C·cm²/W, or within any range defined between any two of the foregoing values, such as 0.05°C·cm²/W to 0.35°C·cm²/W, 0.15°C·cm²/W to 0.3°C·cm²/W, or 0.2°C·cm²/W to 0.3°C·cm²/W, for example.

In some exemplary embodiments, a thermal interface material including a coloring agent as described above is combined with a solvent, such as an isoparaffinic fluid, to form a dispensable thermal interface material. In some exemplary embodiments, the dispensable thermal interface includes an amount as little as 1 wt. %, 2 wt.%, 5 wt.%, as great as 10 wt.%, 15 wt.%, 20 wt.% of the solvent, or within any range defined between any two of the foregoing values, such as 1 wt.% to 20 wt.% or 5 wt.% to 10 wt.%, for example, based on 100 wt.% of the thermal interface material without the solvent.

In some exemplary embodiments, the dispensable thermal interface material as described above has the viscosity in the range of 10 Pa.s to 100,000 Pa.s, or more particularly in the range of 100 Pa.s to 10,000 Pa.s at room temperature. An exemplary viscosity test method standard is DIN 53018. In one particular embodiment, the viscosity is tested by Brookfield Rheometer with shear rate 2 s⁻¹. In some exemplary embodiments, the dispensable thermal interface material as described above has the dispense rate in the range of 1 g/min to 1000 g/min, or more particularly in the range of 10 g/min to 100 g/min. In one particular embodiment, the dispense rate is tested under 0.6 MPa pressure with a 10 ml syringe having a 2.54mm (0.1 inch) diameter dispense header opening.

### B. Methods of forming a Thermal Interface Material

In some exemplary embodiments, the TIM is prepared by combining the individual components in a heated mixer and blending the composition together.

In some exemplary embodiments, the TIM is then baked at a temperature as low as 25°C, 50°C, 75°C, 80°C, as high as 100°C, 125°C, 150°C, 170°C, or within any range defined between any two of the foregoing values. In some exemplary embodiments, the TIM is baked for as little as 0.5 minutes, 1 minute, 30 minutes, 1 hour, 2 hours, as long as 8 hours, 12 hours, 24 hours, 36, hours, 48 hours, or within any range defined between any two of the foregoing values. An exemplary baking condition is 80°C for 30 minutes.

### C. Applications utilizing the Thermal Interface Material

Referring again to FIG. 1, in some exemplary embodiments, the thermal interface material including a pigment or dye is positioned as a TIM 1 between an electronic component 12 and a heat spreader 14, as indicated by TIM 18. In some exemplary embodiments, the thermal interface material including a pigment or dye is positioned as a TIM 2 between an a heat spreader 14 and a heat sink 16, as indicated by TIM 20. In some exemplary embodiments, the thermal interface material including a pigment or dye is positioned as a TIM 1.5 (not shown) between an electronic component 12 and a heat sink 16.

### EXAMPLES

Thermal interface materials were prepared according to the formulations provided in Table 1.

**TABLE 1: Formulations (wt.%) for Comparative Examples 1 and 2**

| | ***Comp. Ex. 1*** | ***Comp. Ex. 2*** |
|---|---|---|
| Elastomer | 8.69 | 6.22 |
| First wax | 2.48 | 1.78 |
| Second wax | 0.62 | - |
| Antioxidant | 0.2 | 0.5 |
| Coupling agent | 1.5 | 0.67 |
| Thermally conductive filler | 85.91 | 90.83 |
| Crosslinker | 0.6 | - |

The elastomer used was Kraton elastomer (a hydroxyl-terminated ethylene butylene copolymer, specialty mono-ol). The first wax was a microcrystalline wax with a melting point of about 45°C. The second wax was an amorphous, low density polyethylene homopolymer. The coupling agent was a titanium-based coupling agent. The thermally conductive filler was aluminum particles having a particle size greater than 1 micron. The crosslinker was a Cymel alkylated melamine formaldehyde resin.

To prepare each Comparative Examples, the elastomer waxes, and antioxidant were combined and blended in a heated mixer until the combination had melted and had a substantially homogeneous appearance. The coupling agent, thermally conductive filler, and crosslkiners were then added, with the mixture being blended after each addition until a substantially homogeneous appearance was achieved. The final formulation was added to an isopar-HP solvent, which constituted 9wt% of the total mixture weight. The final combination had a homogeneous appearance.

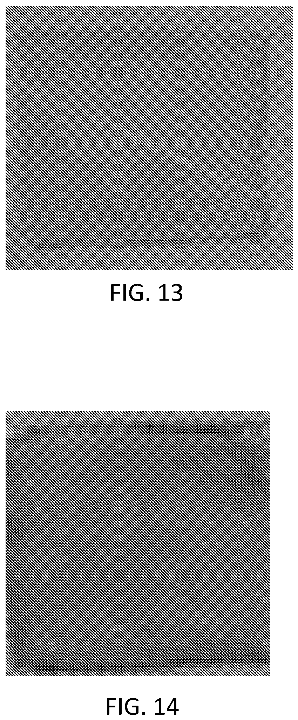

Figures 2A and 2B show the thermal interface material of Comparative Example 1 screen printed at 0.5 mm on paper and a magnesium aluminum alloy substrate. Figure 13 shows the thermal interface material of Comparative Example 2 screen printed on a substrate.

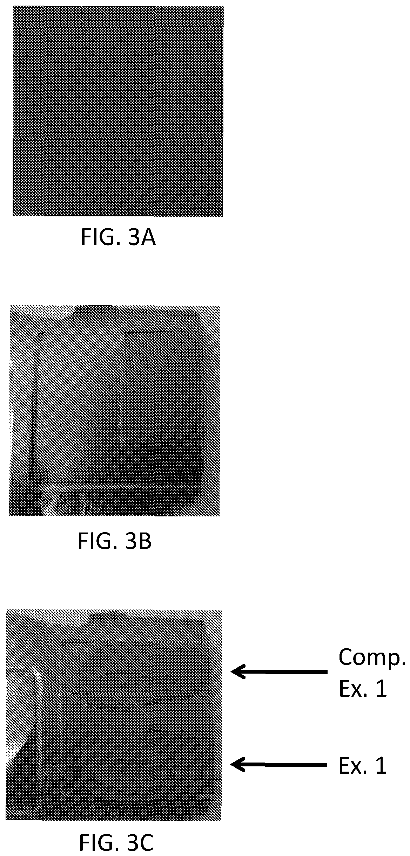

Examples 1-10 were prepared by adding a coloring agent according to Table 2 to 100 grams of Comparative Example 1. Each mixture was then stirred with a speed mixer under 3000 revolutions per minute (rpm) for 5 minutes. Example 11 was prepared by adding a coloring agent to 100 grams of Comparative Example 2. The mixture was then stirred with a speed mixer under 34 revolutions per minute (rpm) for 60 minutes. The resulting paste was then screened onto a substrate. Examples 1-10 were visually compared to Comparative Example 1 and Example 11 was visually compared to Comparative Example 2 for any color differentiation. The results are shown in Figures 3A-12C and 14, and summarized in Table 2 below.

**TABLE 2: Formulations for Examples 1-11 and Visual comparison of Examples 1-10 with Comparative Example 1 and Example 11 with Comparative Example 2. In claim 1 the coloring agent comprises an organic pigment. Accordingly, Examples 1 to 5 and 7 to 11 are not according to the invention. Example 6 is according to the invention.**

| | Additive | Additive (g) | Comp. Ex. 1 (g) | Comp. Ex. 2 (g) | Color Difference |
|---|---|---|---|---|---|
| Ex. 1 | Carbon black | 1 | 100 | - | No |
| Ex. 2 | Iron red | 10 | 100 | - | Yes |
| Ex. 3 | Iron yellow | 10 | 100 | - | Yes |
| Ex. 4 | Iron green | 10 | 100 | - | No |
| Ex. 5 | Iron blue | 10 | 100 | - | Yes |
| Ex. 6 | Red pigment | 1 | 100 | - | Yes |
| Ex. 7 | Red dye | 1 | 100 | - | No |
| Ex. 8 | Yellow dye | 1 | 100 | - | No |
| Ex. 9 | Blue dye | 1 | 100 | - | No |
| Ex. 10 | Purple dye | 1 | 100 | - | No |
| Ex. 11 | Carbon black | 2 | - | 100 | No |

In Example 1, the added coloring agent was carbon black supplied by Guoyao Group Chemical Reagent Co., Ltd. having a particle size such that 95 wt.% passes through a 35 µm screen. As shown in Table 2 and Figures 3A - 3C, the addition of the carbon black did not result in a significantly detectable difference in color between Comparative Example 1 and Example 1.

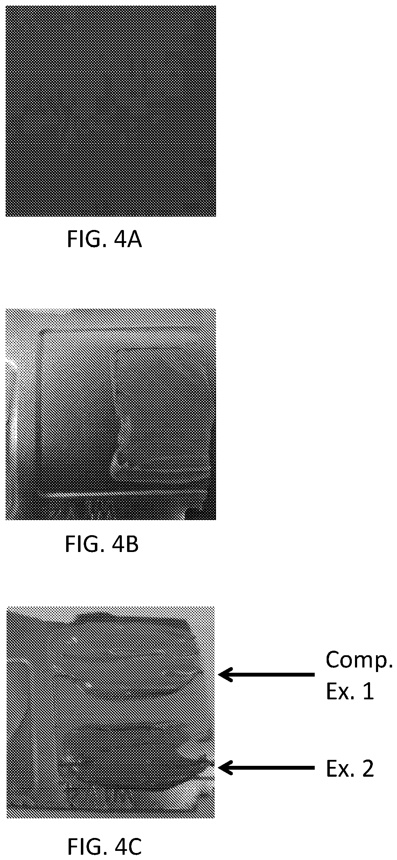

In Example 2, the added coloring agent was α-Fe₂O₃ supplied by Shanghai Baiyan Industrial Co., Ltd. As shown in Table 2 and Figures 4A - 4C, the addition of the inorganic iron red pigment resulted in a visually significant detectable difference in color as perceived by a human eye between Comparative Example 1 and Example 2.

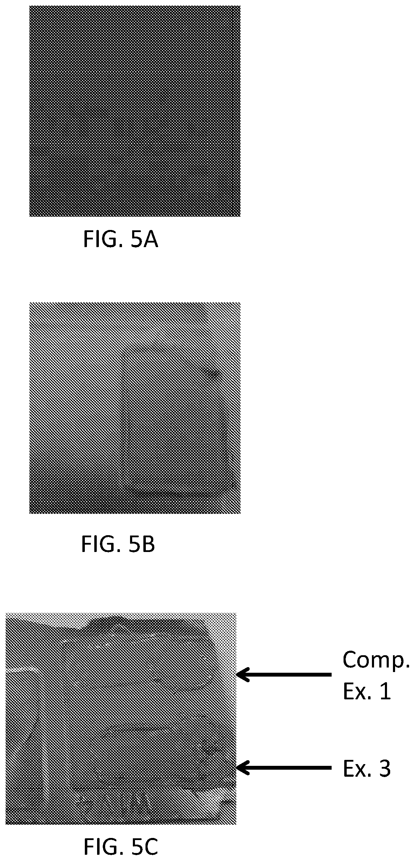

In Example 3, the added coloring agent was α-Fe₂O₃·H₂O supplied by Shanghai Baiyan Industrial Co., Ltd. and Sinopharm Chemical Regent Co., Ltd. As shown in Table 2 and Figures 5A - 5C, the addition of the inorganic iron yellow pigment resulted in a visually significant detectable difference in color as perceived by a human eye between Comparative Example 1 and Example 3.

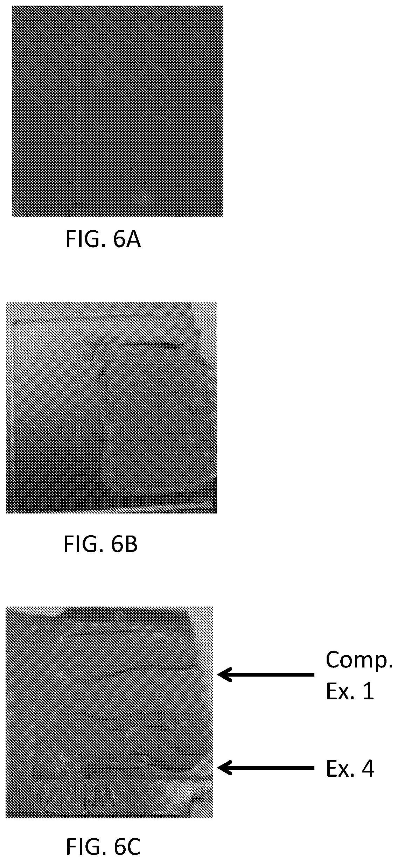

In Example 4, the added coloring agent was a mixture of α-Fe₂O₃·H₂O and Fe₃O₄, supplied by Shanghai Baiyan Industrial Co., Ltd. As shown in Table 2 and Figures 6A - 6C, the addition of the inorganic iron green pigment did not result in a visually significant detectable difference in color as perceived by a human eye between Comparative Example 1 and Example 4.

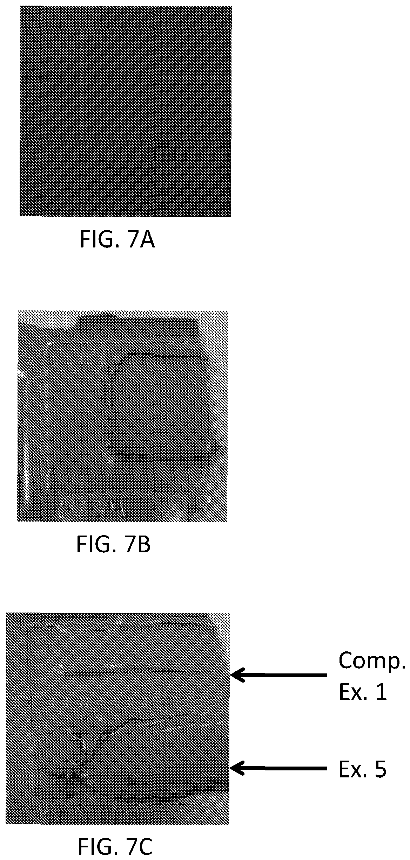

In Example 5, the added coloring agent was Fe₃O₄supplied by Shanghai Baiyan Industrial Co., Ltd. and Sinopharm Chemical Regent Co., Ltd. As shown in Table 2 and Figures 7A - 7C, the addition of the inorganic iron blue pigment resulted in a visually significant detectable difference in color as perceived by a human eye between Comparative Example 1 and Example 5.

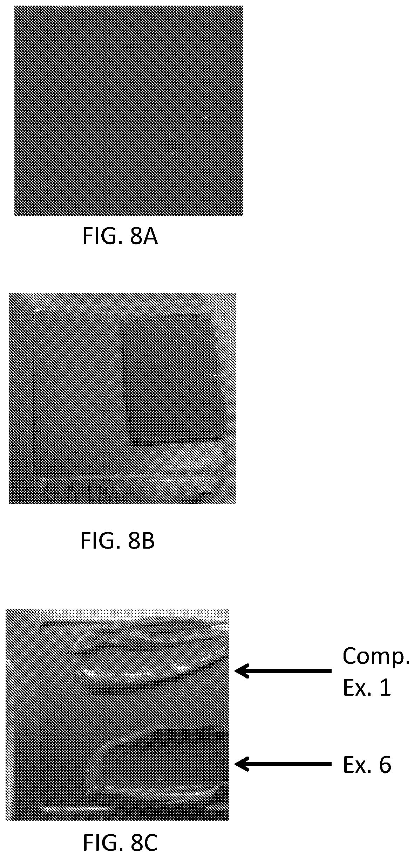

In Example 6, the added coloring agent was Novoperm Carmine H3FC as supplied by Clariant Co. As shown in Table 2 and Figures 8A - 8C, the addition of the organic red pigment resulted in a visually significant detectable difference in color as perceived by a human eye between Comparative Example 1 and Example 6.

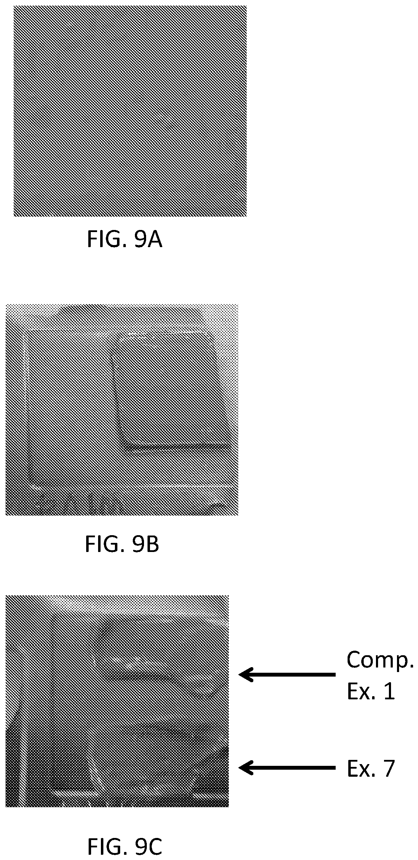

In Example 7, the added coloring agent was Solvaperm Red PFS as supplied by Clariant Co. As shown in Table 2 and Figures 9A - 9C, the addition of the organic red dye did not result in a visually significant detectable difference in color as perceived by a human eye between Comparative Example 1 and Example 7.

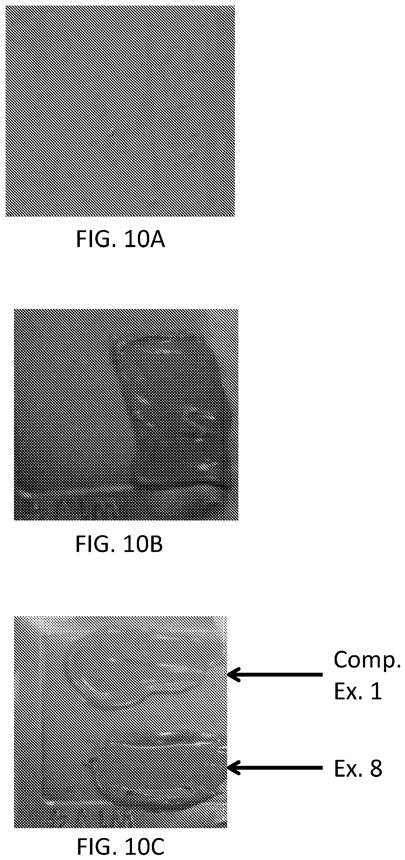

In Example 8, the added coloring agent was Fat Yellow 3G as supplied by Clariant Co. As shown in Table 2 and Figures 10A - 10C, the addition of the organic yellow dye did not result in a visually significant detectable difference in color as perceived by a human eye between Comparative Example 1 and Example 8.

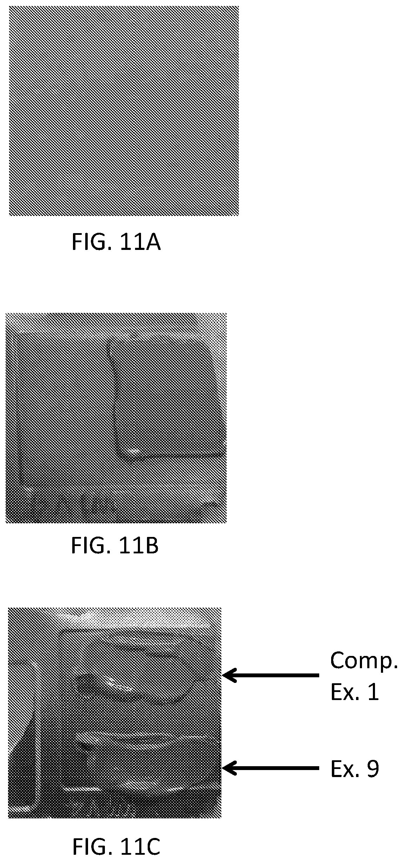

In Example 9, the added coloring agent was Fat Blue B 01 as supplied by Clariant Co. As shown in Table 2 and Figures 11A- 11C, the addition of the organic blue dye did not result in a visually significant detectable difference in color as perceived by a human eye between Comparative Example 1 and Example 9.

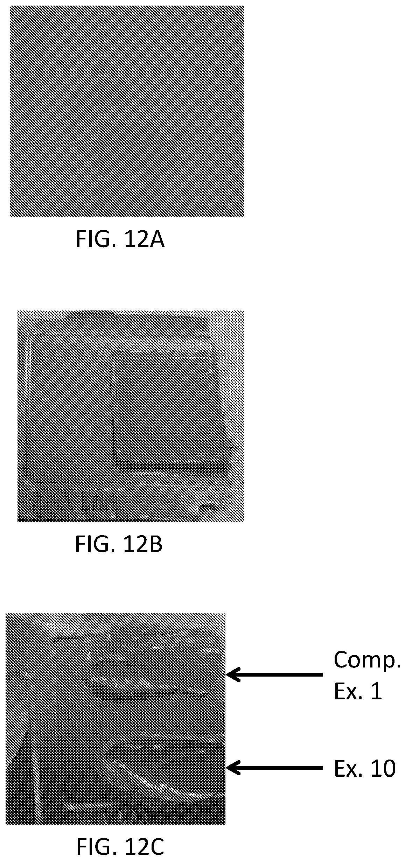

In Example 10, the added coloring agent was Solvaperm Red Violet R as supplied by Clariant Co. As shown in Table 2 and Figures 12A - 12C, the addition of the organic purple dye did not result in a visually significant detectable difference in color as perceived by a human eye between Comparative Example 1 and Example 10.

In Example 11, the added coloring agent was carbon black supplied by Guoyao Group Chemical Reagent Co., Ltd. having a particle size such that 95 wt.% passes through a 35 µm screen. As shown in Table 2, the addition of the carbon black did not result in a visually significant detectable difference in color as perceived by a human eye between Comparative Example 2, as shown in Figure 13, and Example 11, as shown in Figure 14.

As shown in Table 2 above, the formulations including any of the coloring agents α-Fe₂O₃; α-Fe₂O₃·H₂O; and Fe₃O₄, and Formula (I), as used in Examples 2, 3, 5, and 6, exhibited a color differentiation compared to that of Comparative Example 1, which did not include a coloring agent. The formulations prepared with the remaining coloring agents, as in Examples 1, 4, and 7-11 did not exhibit color differentiation compared to the respective comparative examples. As above, Examples 1 to 5 and 7 to 11 are not according to the invention. Example 6 is according to the invention.

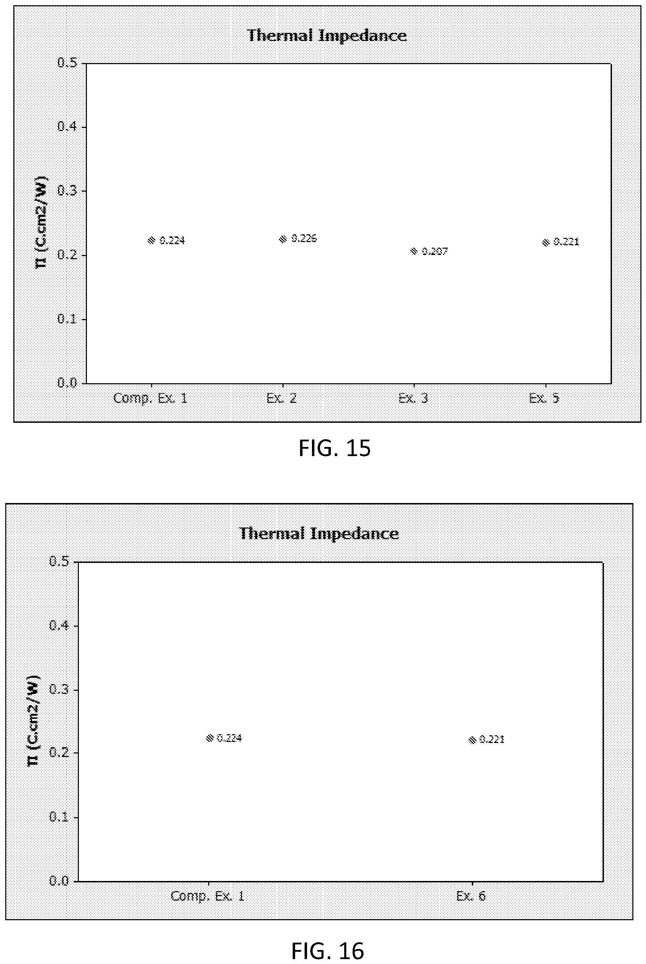

Referring next to Figures 15 and 16, the thermal impedance of Comparative Example 1, Example 2, Example 3, Example 5, and Example 6 is shown in Table 3 shown below.

**TABLE 3: Thermal Impedance Values for Comparative Example 1, Example 2, Example 3, Example 5, and Example 6**

| **Examples** | **Thermal Impedance (°C·cm²/W)** |
|---|---|
| Comparative Example 1 | 0.224 |
| Example 2 | 0.226 |
| Example 3 | 0.207 |
| Example 5 | 0.221 |
| Example 6 | 0.221 |

As shown in Figures 15 and 16, the addition of the particular coloring agents resulted in a similar thermal impedance compared to Comparative Example 1. As above, Examples 1 to 5 and 7 to 11 are not according to the invention. Example 6 is according to the invention.

While this invention has been described as having exemplary designs, the present invention can be further modified within scope of this disclosure. This application is intended to cover such departures from the present disclosure as come within known or customary practice in the art to which this invention pertains and which fall within the limits of the appended claims.

## Claims

1. A thermal interface material comprising:
at least one polymer present in an amount of 5 wt.% to 10 wt.%;
at least one thermally conductive filler present in an amount of 85 wt.% to 95 wt. %;
0.1 wt.% to 5 wt.% of a phase change material comprising at least one wax; and
at least one coloring agent present in an amount of 0.5 wt.% to 20 wt.% based on 100 wt.% of the thermal interface material without the coloring agent, and selected from the group consisting of: an organic pigment, wherein the organic pigment has a formula selected from the group consisting of Formulas (I)-(XVI): 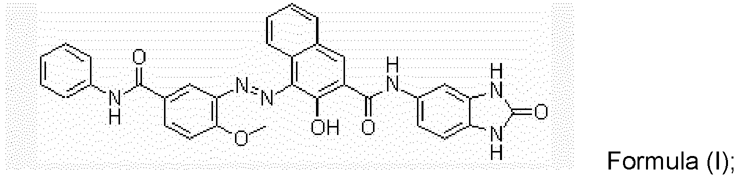 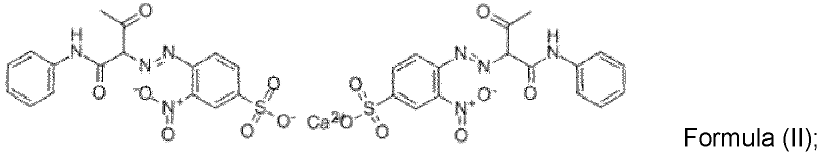 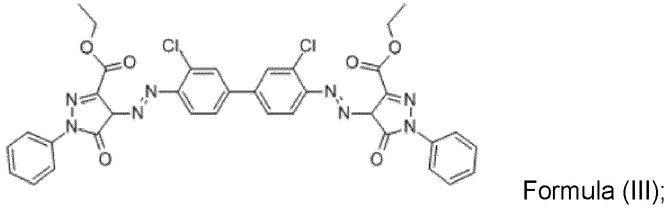 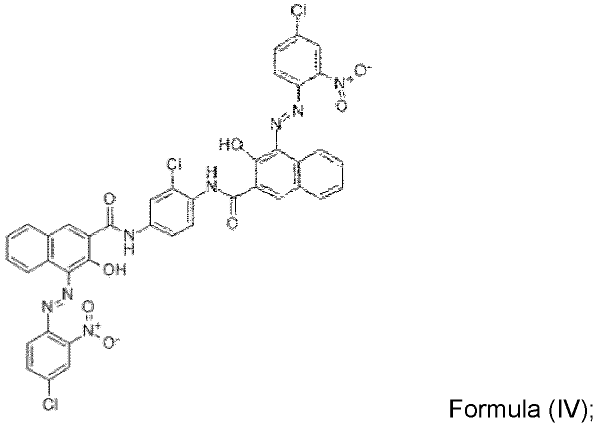 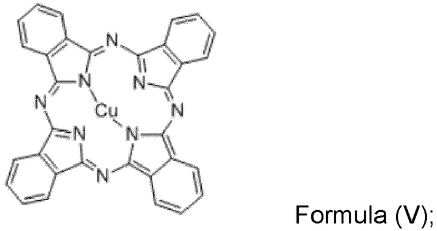 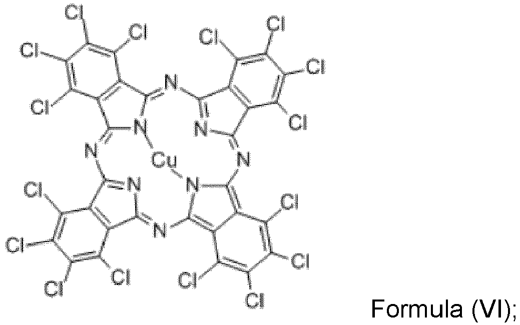 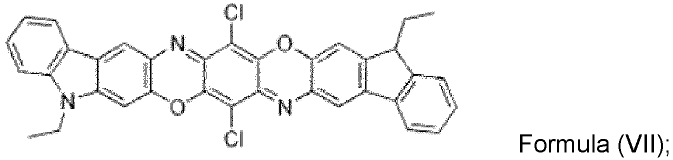 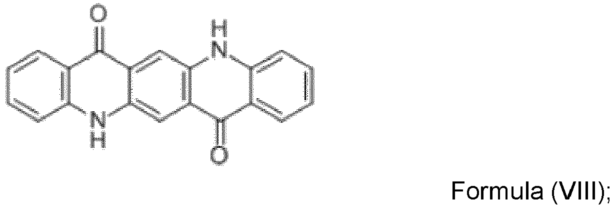 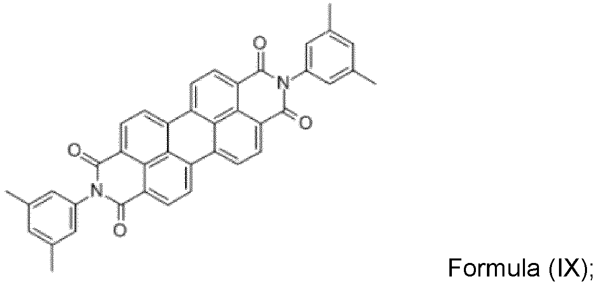 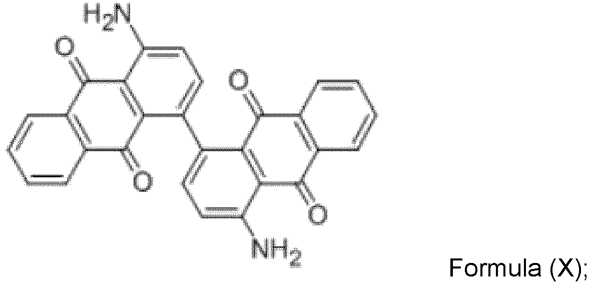 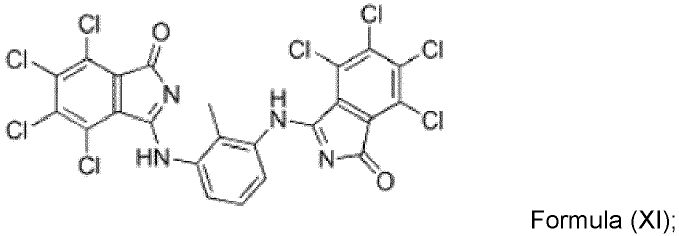 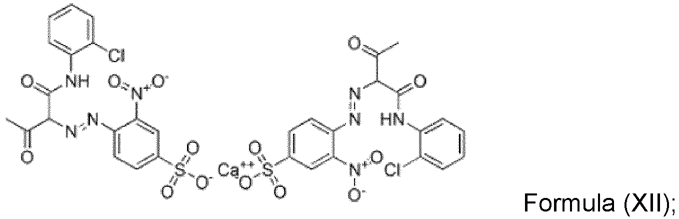 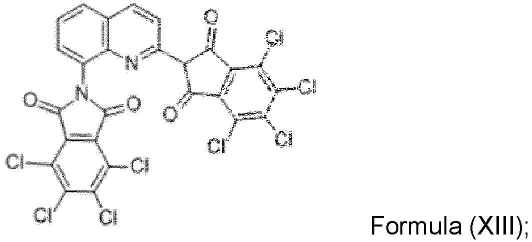 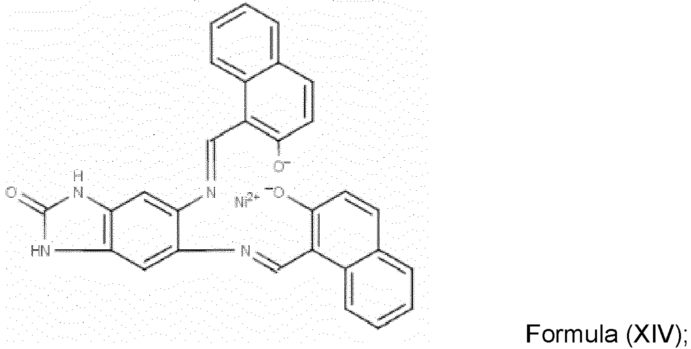 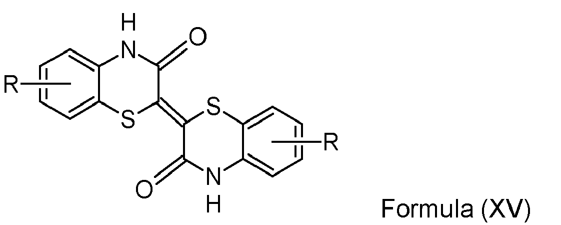 wherein each R is independently selected from H, alkyl, aryl, and halogen; and

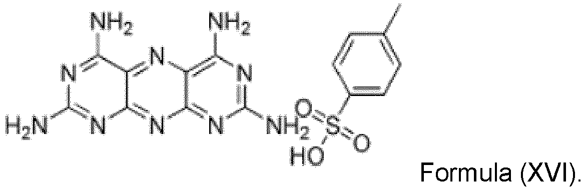

2. The thermal interface material of claim 1, wherein the coloring agent is an organic pigment of Formula (I).

3. The thermal interface material of claim 2, wherein the thermal interface material comprises 0.5 wt.% to 2 wt.% of the coloring agent based on 100 wt.% of the thermal interface material without the coloring agent.

4. The thermal interface material of claim 1, wherein the thermal interface material comprises 1 wt. % to 20 wt. % of the coloring agent based on 100 wt. % of the thermal interface material without the coloring agent.

5. The thermal interface material of claim 1, wherein the thermally conductive filler comprises aluminum particles.

6. The thermal interface material of claim 5, wherein the aluminum particles are at least 80 wt.% of the thermal interface material, based on 100 wt.% of the thermal interface material without the coloring agent.

7. A dispensable thermal interface material comprising:
the thermal interface material of claim 1; and
at least one solvent.

8. The dispensable thermal interface material of claim 7, wherein the solvent is an isoparaffinic fluid.

9. The dispensable thermal interface material of claim 7, wherein the solvent comprises from 1 wt.% to 20 wt.% based on the total weight of a mixture including the thermal interface material and the solvent.

10. The dispensable thermal interface material of claim 7, wherein the coloring agent is an organic pigment of Formula (I).

11. An electronic component comprising:
a heat sink;
a substrate;
the thermal interface material of claim 1, wherein the thermal interface material is positioned between the heat sink and the substrate.

## Patentansprüche

1. Thermisches Zwischenmaterial, umfassend:
mindestens ein Polymer, das in einer Menge von 5 Gew.-% bis 10 Gew.-% vorhanden ist;
mindestens einen wärmeleitfähigen Füllstoff, der in einer Menge von 85 Gew.-% bis 95 Gew.-% vorhanden ist;
0,1 Gew.-% bis 5 Gew.-% eines Phasenwechselmaterials, das mindestens ein Wachs umfasst; und
mindestens ein Färbemittel, das in einer Menge von 0,5 Gew.-% bis 20 Gew.-% vorhanden ist, bezogen auf 100 Gew.-% des thermischen Zwischenmaterials ohne das Färbemittel, und ausgewählt ist aus der Gruppe, bestehend aus: einem organischen Pigment, wobei das organische Pigment eine Formel aufweist, die ausgewählt ist aus der Gruppe, bestehend aus den Formeln (I)-(XVI): 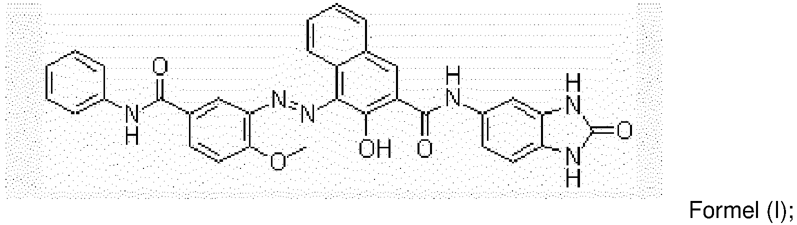 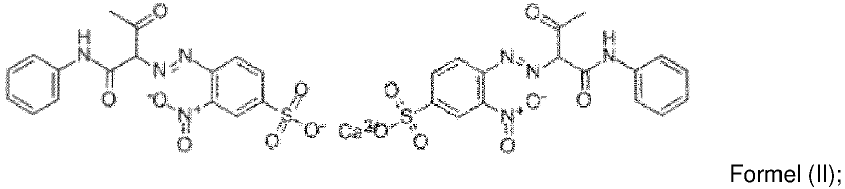 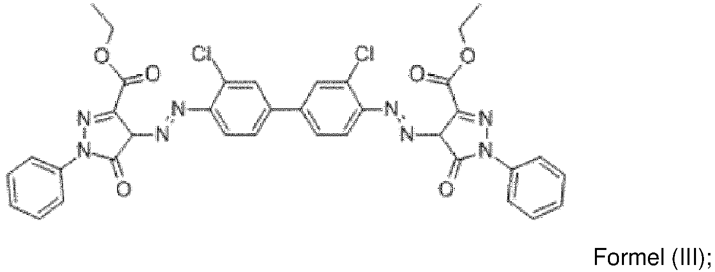 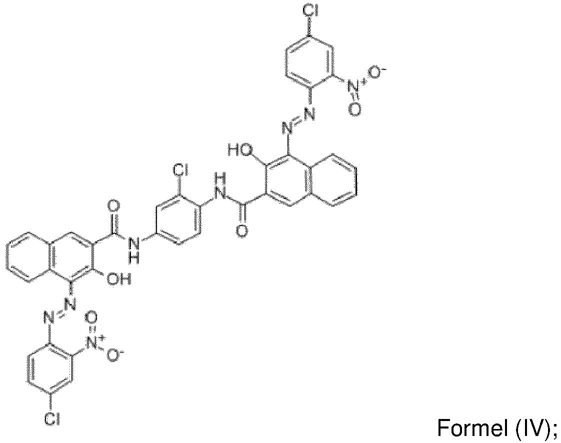 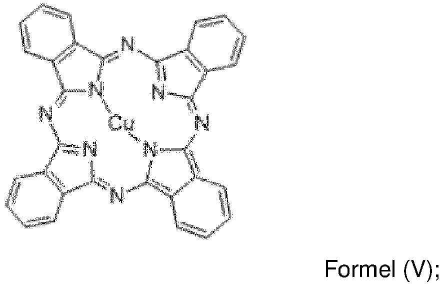 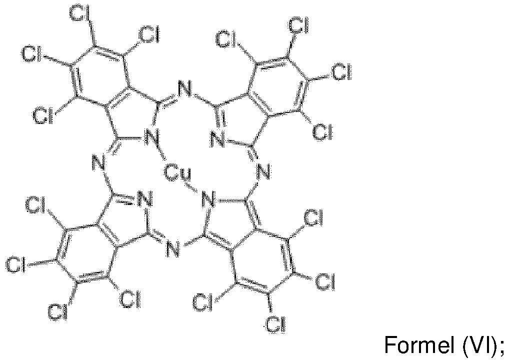 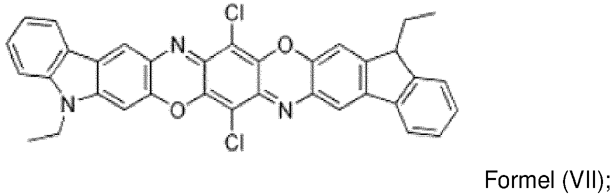 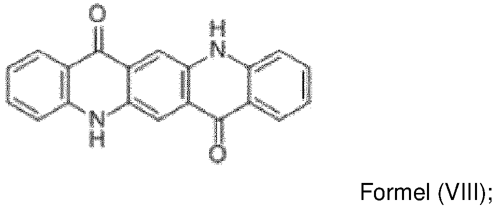 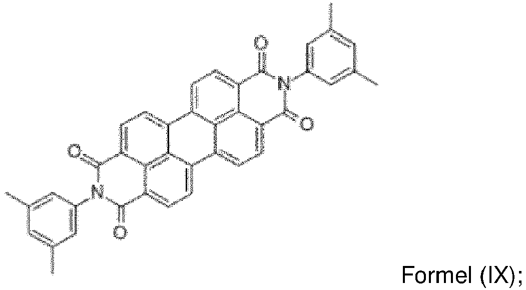 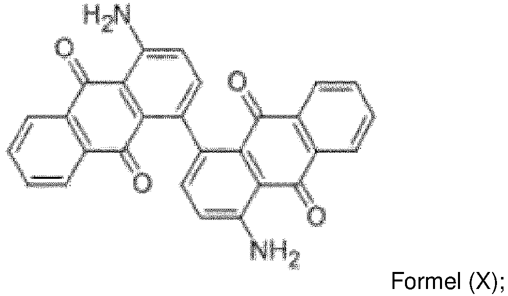 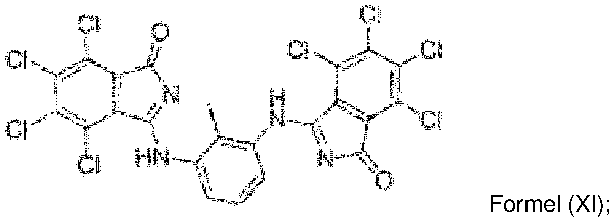 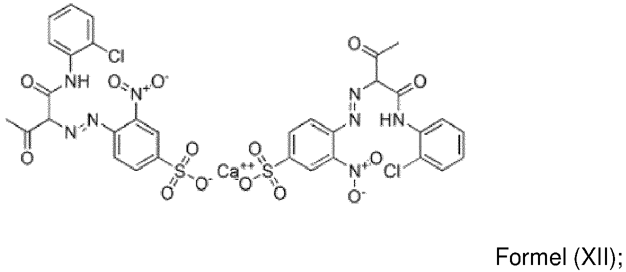 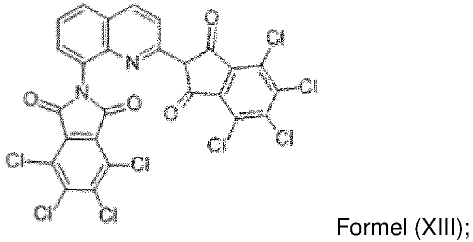 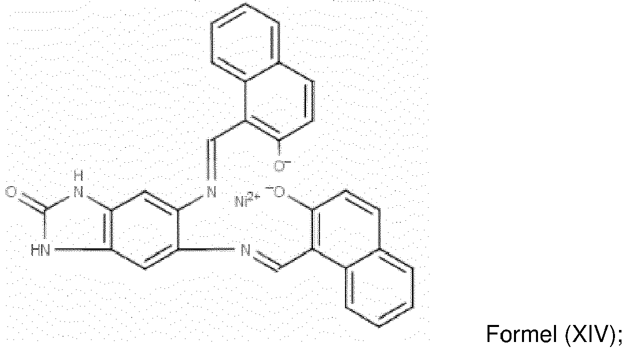 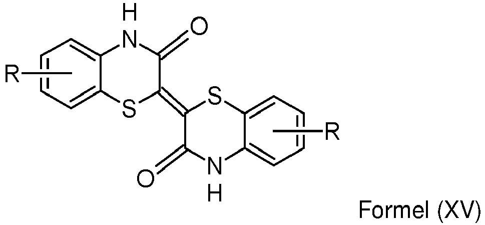 wobei jedes R unabhängig ausgewählt ist aus H, Alkyl, Aryl und Halogen; und

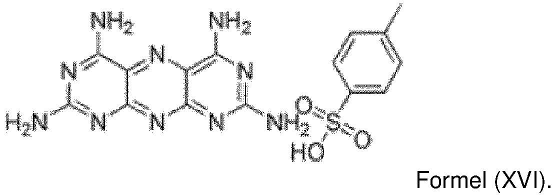

2. Thermisches Zwischenmaterial nach Anspruch 1, wobei das Färbemittel ein organisches Pigment der Formel (I) ist.

3. Thermisches Zwischenmaterial nach Anspruch 2, wobei das thermische Zwischenmaterial 0,5 Gew.-% bis 2 Gew.-% des Färbemittels umfasst, bezogen auf 100 Gew.-% des thermischen Zwischenmaterials ohne das Färbemittel.

4. Thermisches Zwischenmaterial nach Anspruch 1, wobei das thermische Zwischenmaterial 1 Gew.-% bis 20 Gew.-% des Färbemittels umfasst, bezogen auf 100 Gew.- % des thermischen Zwischenmaterials ohne das Färbemittel.

5. Thermisches Zwischenmaterial nach Anspruch 1, wobei der wärmeleitfähige Füllstoff Aluminiumpartikel umfasst.

6. Thermisches Zwischenmaterial nach Anspruch 5, wobei die Aluminiumpartikel mindestens 80 Gew.-% des thermischen Zwischenmaterials betragen, bezogen auf 100 Gew.- % des thermischen Zwischenmaterials ohne das Färbemittel.

7. Dispensierbares thermisches Zwischenmaterial, umfassend:
das thermische Zwischenmaterial nach Anspruch 1; und
mindestens ein Lösungsmittel.

8. Dispensierbares thermisches Zwischenmaterial nach Anspruch 7, wobei das Lösungsmittel eine isoparaffinische Flüssigkeit ist.

9. Dispensierbares thermisches Zwischenmaterial nach Anspruch 7, wobei das Lösungsmittel 1 Gew.-% bis 20 Gew.-% umfasst, bezogen auf das Gesamtgewicht einer Mischung, die das thermische Zwischenmaterial und das Lösungsmittel enthält.

10. Dispensierbares thermisches Zwischenmaterial nach Anspruch 7, wobei das Färbemittel ein organisches Pigment der Formel (I) ist.

11. Elektronische Komponente, umfassend:
einen Kühlkörper;
ein Substrat;
das thermische Zwischenmaterial nach Anspruch 1, wobei das thermische Zwischenmaterial zwischen dem Kühlkörper und dem Substrat angeordnet ist.

## Revendications

1. Matériau d'interface thermique comprenant :
au moins un polymère présent à hauteur de 5 % en poids à 10 % en poids ;
au moins une charge thermoconductrice présente à hauteur de 85 % en poids à 95 % en poids ;
0,1 % en poids à 5 % en poids d'un matériau à changement de phase comprenant au moins une cire ; et
au moins un agent colorant présent à hauteur de 0,5 % en poids à 20 % en poids sur la base de 100 % en poids du matériau d'interface thermique sans l'agent colorant, et choisi dans le groupe constitué par : un pigment organique, le pigment organique ayant une formule choisie dans le groupe constitué par les formules (I) à (XVI) : 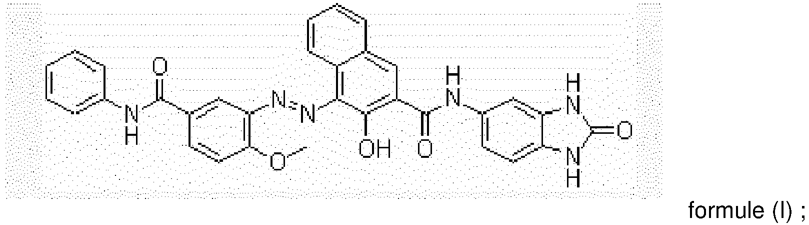 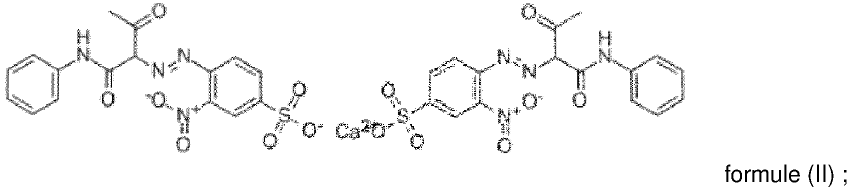 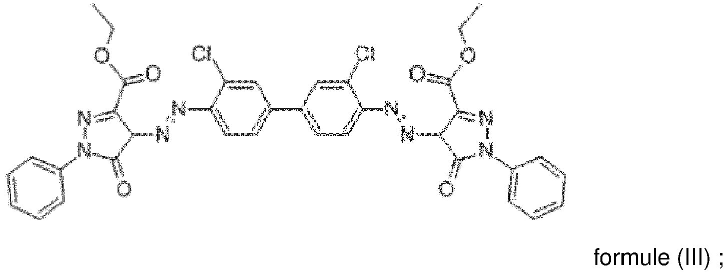 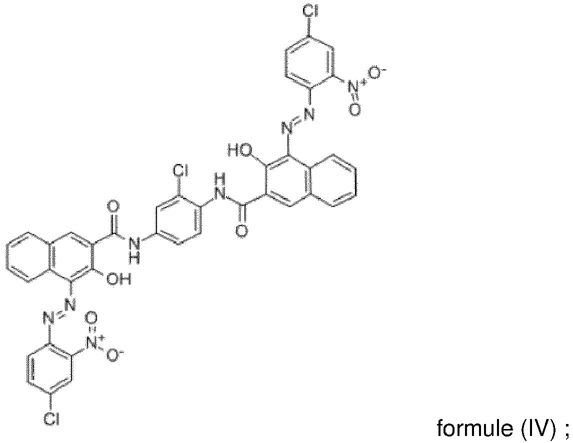 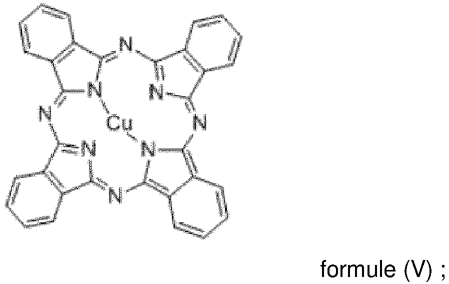 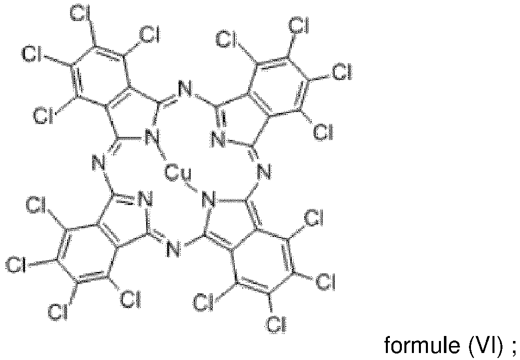 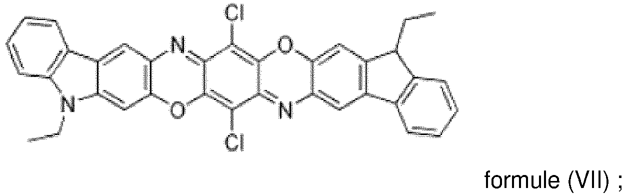 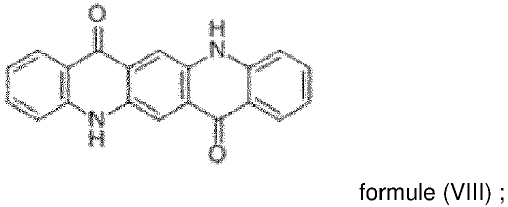 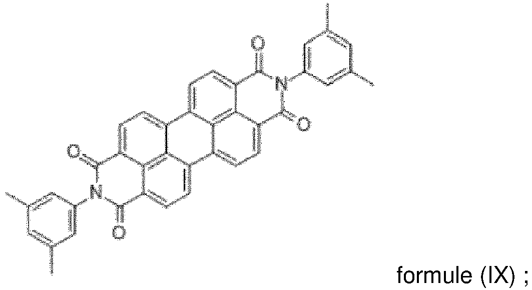 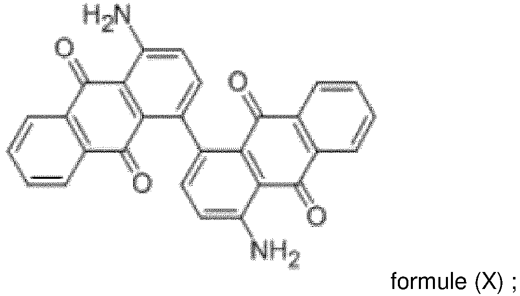 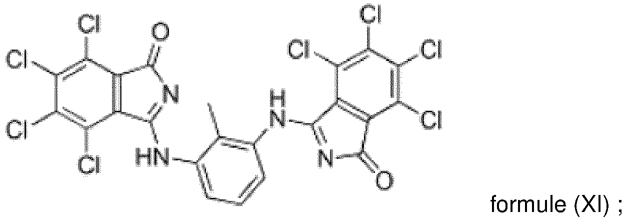 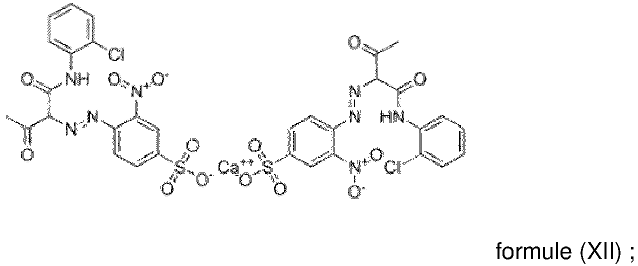 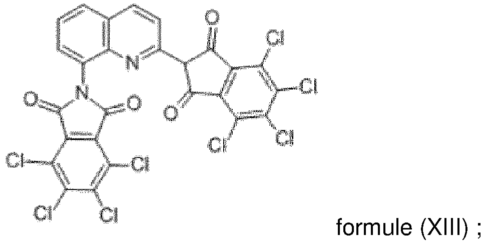 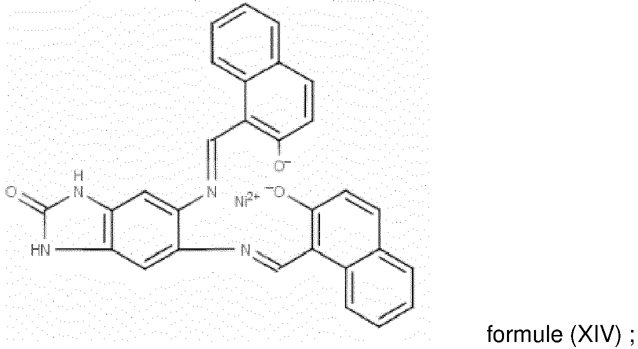 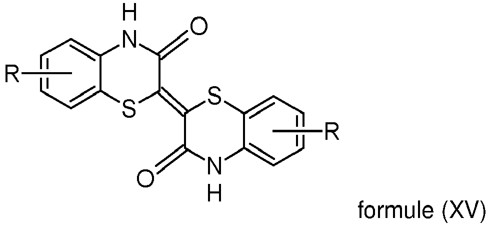 dans laquelle chaque R est indépendamment choisi parmi H, alkyle, aryle et halogène ; et

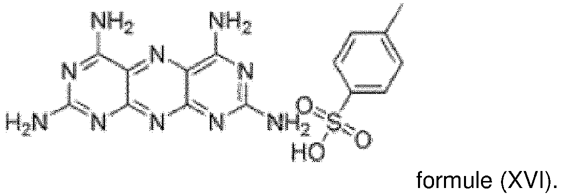

2. Matériau d'interface thermique selon la revendication 1, dans lequel l'agent colorant est un pigment organique de formule (I).

3. Matériau d'interface thermique selon la revendication 2, dans lequel le matériau d'interface thermique comprend entre 0,5 % en poids et 2 % en poids de l'agent colorant sur la base de 100 % en poids du matériau d'interface thermique sans l'agent colorant.

4. Matériau d'interface thermique selon la revendication 1, dans lequel le matériau d'interface thermique comprend entre 1 % en poids et 20 % en poids de l'agent colorant sur la base de 100 % en poids du matériau d'interface thermique sans l'agent colorant.

5. Matériau d'interface thermique selon la revendication 1, dans lequel la charge thermoconductrice comprend des particules d'aluminium.

6. Matériau d'interface thermique selon la revendication 5, dans lequel les particules d'aluminium représentent au moins 80 % en poids du matériau d'interface thermique, sur la base de 100 % en poids du matériau d'interface thermique sans l'agent colorant.

7. Matériau d'interface thermique dispersable comprenant :
le matériau d'interface thermique selon la revendication 1 ; et
au moins un solvant.

8. Matériau d'interface thermique dispersable selon la revendication 7, dans lequel le solvant est un fluide isoparaffinique.

9. Matériau d'interface thermique dispersable selon la revendication 7, dans lequel le solvant comprend entre 1 % en poids et 20 % en poids sur la base du poids total d'un mélange comprenant le matériau d'interface thermique et le solvant.

10. Matériau d'interface thermique dispersable selon la revendication 7, dans lequel l'agent colorant est un pigment organique de formule (I).

11. Composant électronique comprenant :
un dissipateur thermique ;
un substrat ;
matériau d'interface thermique selon la revendication 1, dans lequel le matériau d'interface thermique est positionné entre le dissipateur thermique et le substrat.
